Europäisches Patentamt

European Patent Office

Office européen des brevets

(11) Veröffentlichungsnummer: **0 275 094 B1**

# EUROPÄISCHE PATENTSCHRIFT

(45) Veröffentlichungstag der Patentschrift: **29.07.92**

(51) Int. Cl.5: **G01R 31/28**

(21) Anmeldenummer: **88100400.6**

(22) Anmeldetag: **13.01.88**

(54) **Anordnung zum Prüfen von integrierten Schaltkreisen.**

(30) Priorität: **16.01.87 DE 3701202**

(43) Veröffentlichungstag der Anmeldung:
**20.07.88 Patentblatt 88/29**

(45) Bekanntmachung des Hinweises auf die
Patenterteilung:
**29.07.92 Patentblatt 92/31**

(84) Benannte Vertragsstaaten:
**AT BE CH DE FR GB IT LI NL**

(56) Entgegenhaltungen:
**FR-A- 2 356 950**

**IBM TECHNICAL DISCLOSURE BULLETIN, Band 28, Nr. 4, September 1985, Seiten 1791-1792, New York, US: "Tester for electrostatic-discharge faults in integrated circuits"**

**NACHRICHTENTECHNISCHE ZEITSCHRIFT N.T.Z., Band 28, Heft 9, September 1975, Seiten K340-K342, München, DE; S. SEINECKE: "Ein Prüfautomat für digitale Schaltkreise im Subnanosekundenbereich"**

**TOUTE L'ELECTRONIOUE, Nr. 517, Oktober 1986, Seiten 4-5, Paris, FR: "Un testeur auto-matique de sensibilité aux ESD"**

(73) Patentinhaber: **Siemens Nixdorf Informations-systeme AG
Otto-Hahn-Ring 6
W-8000 München 83(DE)**

(72) Erfinder: **Lieske, Normen, Dr.
Pfarrweg 22
W-8019 Steinhöring(DE)**
Erfinder: **Greisle, Gerhard, Dipl.-Ing.
Gröbenzeller Strasse 3
W-8000 München 50(DE)**
Erfinder: **Bethäuser, Ulrich
Dr. Böttcher Strasse 35
W-8000 München 60(DE)**

(74) Vertreter: **Fuchs, Franz-Josef, Dr.-Ing. et al
Postfach 22 13 17
W-8000 München 22(DE)**

## Beschreibung

Die Erfindung betrifft eine Anordnung zum Prüfen von integrierten Schaltkreisen auf Empfindlichkeit gegenüber elektrostatischen Entladungen an den Anschlußstiften mit Hilfe einer Hochspannungsentladung bei allen möglichen Kombinationen aus jeweils zwei verschiedenen Anschlußstiften eines integrierten Schaltkreises und zur Messung der Eingangskennlinien dieser Anschlußstifte vor und nach dem Entladungsvorgang.

Es ist zur Charakterisierung der Empfindlichkeit gegenüber elektrostatischen Entladungen (ESD) von integrierten Schaltkreisen bereits bekannt, alle möglichen Anschlußstiftkombinationen aus jeweils zwei verschiedenen Anschlußstiften durch eine Hochspannungsentladung, z.B. einer Entladung eines Kondensators über einen Vorwiderstand zu stressen. Zur Feststellung eines ESD-Fehlers am integrierten Schaltkreis werden die Eingangskennlinien der beiden Anschlußstifte der jeweils betrachteten Anschlußstiftkombinationen vor und nach dem Streßvorgang gemessen und verglichen. Während der Kennlinienmessung an einem Anschlußstift müssen alle anderen Anschlußstifte auf definierte logische Pegel gelegt werden können (Vorpolung).

Bei den bisher bekannten ESD-Testanordnungen wurden die Bausteinanschlüsse mechanisch kontaktiert; der Testablauf war deshalb für eine Automatisierung nicht geeignet.

Im IBM Technical Disclosure Bulletin, Vol. 28 No. 4, September 1985, wird eine Anordnung zum Prüfen von integrierten Schaltkreisen auf Empfindlichkeit gegenüber elektrostatischen Entladungen an den Anschlußstiften mit Hilfe einer Hochspannungsentladung beschrieben. Die Anordnung weist außerdem einen Adapter auf, mit dem die Anschlußstifte des Testbausteines verbunden werden. Außerdem wird das Testverfahren über einen Rechner mit zugehörigen Relaissätzen gesteuert.

Aufgabe der vorliegenden Erfindung ist es, eine Anordnung zum Prüfen von integrierten Schaltkreisen auf Empfindlichkeit gegenüber elektrostatischen Entladungen an den Anschlußstiften zu schaffen, die eine vollautomatische Prüfung jeder gewünschten Kombination von jeweils zwei Anschlußstiften ermöglicht.

Zur Lösung dieser Aufgabe wird gemäß der Erfindung die Anordnung derart ausgebildet, daß die Anschlußstifte des jeweiligen integrierten Schaltkreises mit einem Adapter verbunden sind, der seinerseits mit einer ersten Relaismatrix zur Übertragung der Hochspannungsentladung und mit einer zweiten Relaismatrix zum Anlegen eines logischen Pegels "1" und mit einer dritten Relaismatrix zum Anlegen eines logischen Pegels "0" bzw. Massepegels verbunden ist, daß die drei Relaismatrizen über eine Relaismatrixdecodierung und einer Relaismatrixsteuerung von einem Rechner angesteuert werden und daß an den Rechner zugleich eine Relaissteuerung angeschaltet ist, die weitere Relaissätze zum Anlegen der Versorgungsspannungen, der Hochspannungsentladung und der Kennlinienmeßvorrichtung und der logischen Pegel betätigt.

Dabei ist es vorteilhaft, die Hochspannungsentladung mit Hilfe eines über Widerstände auf- und entladbaren Kondensators durchzuführen.

Durch diese Maßnahmen wird erreicht, daß das Prüfen von integrierten Schaltkreisen auf Empfindlichkeit gegenüber elektrostatischen Entladungen automatisiert durchgeführt werden kann, wodurch die Prüfzeit erheblich verringert wird.

Anhand der Blockschaltbilder nach den FIG 1 bis 3 wird die Erfindung näher erläutert.

Es zeigen

FIG 1 ein Systemschaltbild,

FIG 2 ein Detailschaltbild mit den an das Testbauelement angeschalteten Relaismatrizen, Pegelanschlüssen und der Bausteinversorgung,

FIG 3 ein Detailschaltbild der Hochspannungsentladungsschaltung mit den nachgeschalteten Umschalterelais zum wahlweisen Anlegen der Hochspannungsentladeschaltung oder Kennlinienmeßvorrichtung.

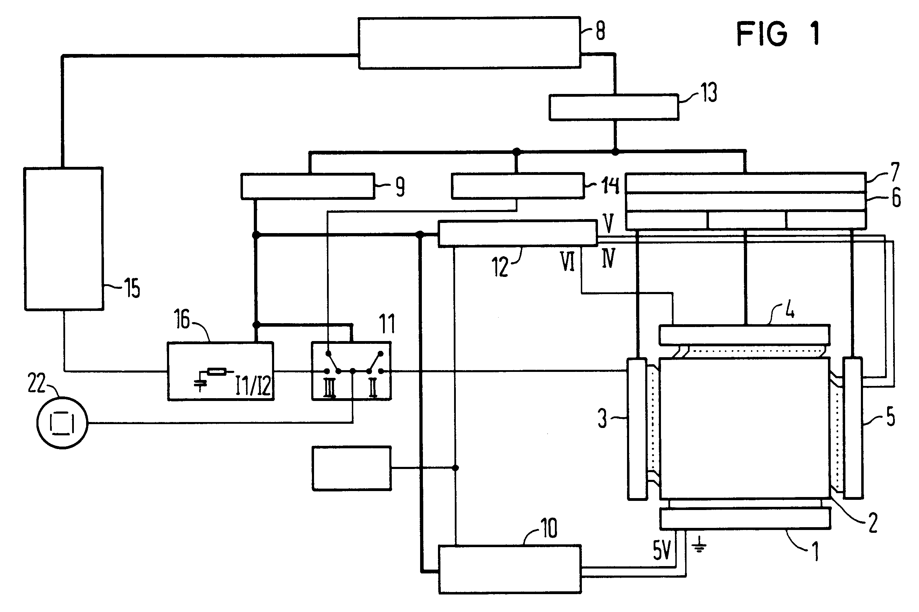

In FIG 1 ist das Gesamtsystem der Prüfanordnung nach der Erfindung dargestellt. Der Rechner 8 ist über ein Optokoppler-Interface 13 sowohl mit der Relaismatrixsteuerung 7 und dem ihr nachgeschalteten Relaismatrixdecodierer 6 sowie der Relaissteuerung 9 und der Kennlinienmeßvorrichtung 14 verbunden. Desgleichen das steuerbare Hochspannungsnetzgerät 15, das zur Spannungsversorgung des Streßsimulators 16, in dem die Hochspannungsentladungen erzeugt werden, erforderlich ist. Die Relaismatrixdecodierung ist sowohl mit der Relaismatrix 3, die zur Durchschaltung der Hochspannungsentladungen dient, als als auch der Relaismatrix 4 zum Anlegen des logischen Pegels "1" und der Relaismatrix 5 zum Anlegen des logischen Pegels "0" an den Testbaustein 1 über den Adapter 2 verbunden. Die stark ausgezogenen Linien stellen dabei die Daten-, Status- und Steuerleitungen dar, während die schwach ausgezogenen Linien Signalleitungen sind.

Für das Anlegen der Versorgungsspannung an den Testbaustein ist der Relaissatz 10 mit den Relais VII1 und VII2 vorgesehen. Für das Anlegen der logischen Pegel der Relaissatz 12 und für das Anlegen der Hochspannungsentladungsschaltung bzw. der Kennlinienmeßvorrichtung 14 der Relaissatz 11 mit den Relais II und III. An diesen Relaissatz ist außerdem das Speicheroszilloskop 22 angeschlossen.

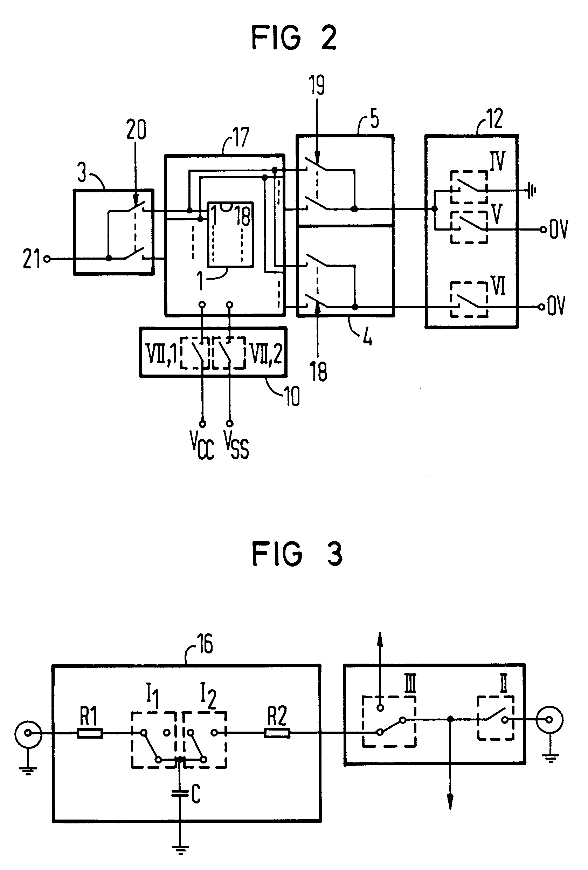

In FIG 2 ist die Testbauelementaufnahme 17 mit den Relaismatrizen 3, 4 und 5 und dem Relaissatz 12 gezeigt. Die Bausteinversorgung wird über den Relaissatz 10 sichergestellt.

Den Relaismatrizen 4 und 5 werden die Steuersignale 18 und 19 vom nicht dargestellten Relaismatrixdecodierer geliefert. Ebenso der Relaismatrix 3 das Steuersignal 20 für die Hochspannungsentladung. Die Steuerklemme 21 stellt den Einspeisepunkt für die Hochspannungsentladung dar, ebenso den Anschluß über den Relaissatz 11 an die Kennlinienmeßvorrichtung 14. Als logischen Pegel "1" wird im vorliegenden Beispiel von einem Pegel von 5 Volt, als logischem Pegel "0" von einem Pegel von 0 Volt ausgegangen.

Der sogenannte Streßsimulator 6, mit dem die Hochspannungsentladung an den Anschlußstiften des Testbausteins durchgeführt wird, ist in FIG 3 dargestellt. Er besteht aus einem Kondensator C, der über den Widerstand R1, z.B. von 1M Ω aufgeladen und über den Widerstand R2, z.B. 1K Ω und über die in der Zeichnung nicht dargestellte Anschlußstiftkombination des Testbausteins entladen wird, wobei die Umschaltung des Kondensators über die Relais I1 und I2 des Streßsimulators 16 erfolgt, und die Zuleitung der Entladungsspannung an die Relaismatrix 3 über den Relaissatz 11 mit den Relais II und III, wobei das Relais III die Umschaltung von der Kennlinienmeßvorrichtung zum Streßsimulator 16 bewirkt. Zwischen den Relais III und II ist eine Abzweigung zur Hochspannungsmessung vorgesehen und vom Relaisausgang des Relais II wird die Verbindung zur nicht dargestellten Relaismatrix 3 hergestellt.

Die für eine schnelle Durchführung des elektrostatischen Belastungstests (ESD) erforderliche wahlfreie Kontaktierung aller Bausteinanschlüsse sowohl einzeln als auch in beliebigen Kombinationen wird durch die elektrische Relaismatrix 3 zur Übertragung der Hochspannungsentladung erreicht. Mit der dazugehörigen Decodierlogik, bestehend aus Relaismatrix-Steuerung 7 und der Relaismatrix-Decodierung 6, werden digitale Ansteuersignale für alle Relais decodiert und die gewünschten logischen Zustände der selektierten Relais gespeichert. Jedes Relais der Relaismatrix 3 kann einzeln gesetzt bzw. rückgesetzt werden; ein gemeinsames Rücksetzen aller Relais der Matrix ist ebenfalls möglich. Gemäß den logischen Zuständen steuern nicht dargestellte Treiber das Öffnen bzw. Schließen der Relais.

Das Anlegen zweier logischer Pegel an beliebige Bausteinanschlüsse während der Kennlinienmessung an einem Bausteinanschlußstift bewerkstelligen die zwei weiteren Relaismatrizen 5 logischer Pegel "0" und logischer Pegel "1". Die digitale Ansteuerung erfolgt auf die gleiche Art wie bei der Relaismatrix 3.

Die Relaissteuerung 9 regelt den Gesamtablauf des EDS-Tests; über sie kann durch unterschiedliche digitale Adressen zwischen dem Hochspannungs-Streß und der Kennlinienmessung gewählt werden.

Während des Hochspannungs-Stresses wird das im Streßsimulator 16 befindliche RC-Glied zyklisch auf- bzw. entladen und das entstehende Hochspannungs-Puls über die Relaismatrix 3 an einen Bausteinanschluß (HV-Pin) geführt. Die zeitliche Schaltabfolge der beteiligten Relais I1, I2, II, III, V wird von der Relaissteuerung 9 festgelegt. Die Kontaktierung des zweiten Bauteileanschlußstiftes (Masse-Pin) der zu stressenden Anschlußstiftkombination wird zuvor von der Relaismatrix 5 durchgeführt.

Für die Kennlinienmessung an einem beliebigen Anschlußstift wird über die Relaissteuerung 9 das RC-Glied von der Relaismatrix 3 getrennt und stattdessen die Kennlinienmessvorrichtung 14 zugeschaltet. Das Anlegen der logischen Pegel an den Baustein erfolgt über die Relaismatrizen 5 und 4 sowie über die Relais IV und VI, die von der Relaissteuerung 9 angewählt werden. Die Versorgungsspannungen für den Baustein werden durch die Relais VII1, VII2 zugeschalet.

Durch die digitale Ansteuerbarkeit aller Funktionen (Steuerung aller Relais bzw. Relaismatrizen über die Relaismatrix-Steuerung 7, Relaismatrix-Decodierung 6 und Relaissteuerung 9) der Hardware wird eine rechnergesteuerte Automatisierung des ED S-Tests ermöglicht.

**Patentansprüche**

1. Anordnung zum Prüfen von integrierten Schaltkreisen (1) auf Empfindlichkeit gegenüber elektrostatischen Entladungen an den Anschlußstiften mit Hilfe einer Hochspannungsentladung bei allen möglichen Kombinationen aus jeweils zwei verschiedenen Anschlußstiften eines integrierten Schaltkreises (1) und zur Messung der Eingangskennlinien dieser Anschlußstifte vor und nach dem Entladungsvorgang, **dadurch gekennzeichnet,** daß die Anschlußstifte des jeweiligen integrierten Schaltkreises (1) mit einem Adapter (2) verbunden sind, der seinerseits mit einer ersten Relaismatrix (3) zur Übertragung der Hochspannungsentladung und mit einer zweiten Relaismatrix (4) zum Anlegen eines logischen Pegels "1" und mit einer dritten Relaismatrix (5) zum Anlegen eines logischen Pegels "0" bzw. Massepegels verbunden ist, daß die drei Relaismatrizen (3,4,5) über eine Relaismatrixdecodierung (6) und eine Relaismatrixsteuerung (7) von einem Rechner (8) angesteuert werden und daß an den Rechner (8) zugleich eine Relaissteuerung (9) angeschaltet ist, die weitere Relaissätze (10,11,12) zum Anlegen der Versorgungsspannungen der Hochspannungsentladung und der Kennlinienmeßvorrichtung (14) und der logischen Pegel betätigt.

2. Anordnung zum Prüfen von integrierten Schaltkreisen nach Anspruch 1, **dadurch gekennzeichnet,** daß die Hochspannungsentladung mit Hilfe eines über Widerstände auf- und entladbaren Kondensators erfolgt.

## Claims

1. Arrangement for testing integrated circuits (1) for sensitivity to electrostatic discharges at the terminal pins with the aid of a high-voltage discharge in all possible combinations consisting of two different terminal pins in each case of an integrated circuit (1) and for measuring the input characteristics of said terminal pins before and after the discharge process, characterised in that the terminal pins of the integrated circuit (1) concerned are connected to an adaptor (2) which is in turn connected to a first relay matrix (3) for transmitting the high-voltage discharge and to a second relay matrix (4) for applying a logic level "1" and to a third relay matrix (5) for applying a logic level "0" or earth level, in that the three relay matrices (3, 4, 5) are triggered by a computer (8) via a relay matrix decoding system (6) and a relay matrix control system (7), and in that a relay control system (9) which actuates further relay groups (10, 11, 12) in order to apply the supply voltages of the high-voltage discharge and of the characteristic measurement device (14) and of the logic level is also connected to the computer (8).

2. Arrangement for testing integrated circuits according to Claim 1, characterised in that the high-voltage discharge takes place with the aid of a capacitor which can be charged and discharged via resistors.

## Revendications

1. Dispositif pour tester la sensibilité de circuits intégrés (1) vis-à-vis de décharges électrostatiques au niveau des broches de raccordement, à l'aide d'une décharge à haute tension, pour toutes les combinaisons possibles formées respectivement de deux broches différentes de raccordement d'un circuit intégré (1) et pour mesurer les courbes caractéristiques d'entrée de ces broches de raccordement avant et après le processus de décharge, caractérisé par le fait que les broches de raccordement du circuit intégré respectif (1) sont raccordées à un adaptateur (2), qui, pour sa part, est relié à une première matrice de relais (3) pour la transmission de la décharge à haute tension et à une seconde matrice de relais (4) pour l'application d'un niveau logique "1" et à une troisième matrice de relais (5) pour l'application d'un niveau logique "0" ou du niveau de masse, que les trois matrices de relais (3,4,5) sont commandées par un calculateur (8) par l'intermédiaire d'une unité (6) de décodage des matrices de relais et d'une unité (7) de commande des matrices de relais, et qu'au calculateur (8) est raccordée simultanément une unité de commande de relais (9), qui actionne d'autres ensembles de relais (10,11,12) pour appliquer les tensions d'alimentation de la décharge à haute tension et du dispositif (14) de mesure des courbes caractéristiques, et des niveaux logiques.

2. Dispositif pour tester des circuits intégrés suivant la revendication 1, caractérisé par le fait que la décharge à haute tension est réalisée à l'aide d'un condensateur pouvant être chargé et déchargé par l'intermédiaire de résistances.

FIG 1

EP 0 275 094 B1

## FIG 2

## FIG 3